# EUROPEAN PATENT SPECIFICATION

(11) **EP 1 324 881 B1**
(45) Date of publication and mention of the grant of the patent: **15.09.2004**
(21) Application number: 00974777.5
(22) Date of filing: 12.10.2000
(51) Int. Cl.: B32B 31/20, H05K 3/00

(54) **MACHINE FOR HOT LAMINATION OF A DRY PHOTORESIST FILM ONTO A BOARD FOR PRINTED CIRCUIT**
MASCHINE ZUR WARMLAMINIERUNG EINES TROCKENFOTORESISTFILMS AUF EINE PLATTE FÜR EINE LEITERPLATTE
MACHINE POUR LA STRATIFICATION A CHAUD D'UN FILM DE PHOTORESIST SEC SUR UNE CARTE DESTINEE A UN CIRCUIT IMPRIME

(43) Date of publication of application: 09.07.2003
(73) Proprietor: Candore, Amedeo, 21020 Bodio Lomnago (IT)
(72) Inventor: Candore, Amedeo, 21020 Bodio Lomnago (IT)
(74) Representative: Pellegri, Alberto
(86) International application number: PCT/IT2000/000406
(87) International publication number: WO 2002/030668

(56) References cited:
- EP-A- 0 314 036
- EP-A- 0 336 358
- EP-A- 0 973 066
- US-A- 3 547 730
- US-A- 4 025 380
- US-A- 4 214 936
- US-A- 6 026 884
- US-A- 6 076 257
- US-A- 6 077 373

## Description

### FIELD OF THE INVENTION

This invention relates to the fabrication of printed circuit board and more in particular to the techniques and machines used for laminating a dry photoresist film onto a board for printed circuit.

### DISCUSSION OF KNOWN TECHNIQUES

The fabrication process of a printed circuit contemplates in one of its earlier steps, the application of a film of photoresist on one or both faces of a copper laminated board for printed circuit to be exposed and polymerized by a UV source through respective photographic mask films of the circuit to be realized.

The layer of photoresist may be applied in liquid form or more often is applied in the form of a dry photoresist film supported on a cover sheet that may be easily peeled off for exposing the photoresist.

For applying the dry-photoresist film on one or on both faces of the board, special hot laminating machines are used that generally comprise a pair of laminating rolls having a metal (steel) core and an external facing of siliconic rubber. The rolls are heated at a temperature sufficient to plastically reflow the photoresist material generally comprised 100°C and 130°C, and are pressed together by pneumatic actuators at an adjustable pressure. The tangential velocity of the rolls, temperature and pressure, are the lamination parameters that are adjusted by the operator to obtain the best adhesion of the photoresist to the copper surface of the board. Productivity reasons impose the use of automatic laminating machines to which the boards and the supported dry photoresist film must be functionally fed in a substantially continuous fashion. While the boards may be fed in sequence, the supported dry film of photoresist is commonly drawn from a supply roll of a continuous ribbon of supported dry film.

To avoid an economically intolerable waste of supported dry photoresist film, the automatic laminating machines are provided with means for tacking the leading edge of the ribbon onto the face of an incoming board, at a precisely predetermined position, generally close to the leading side of the board, by way of heated pressing bars that press the leading edge of the ribbon onto the copper surface for an interval of time sufficient for the softening of the dry photoresist and its firm tacking onto the copper surface.

After such a tacking step, generally lasting from 3 to 5 seconds, the board resumes its travel toward the inlet side of the lamination station, pulling along the tacked ribbon of supported dry photoresist film. In automatic machines of first generation, once the leading edge of the board is caught by the rolls, the movement is arrested again to permit the cutting to measure to the trailing edge of the ribbon. After having cut the required length of dry photoresist supported film ribbon, the board and the cut dry photoresist film restart their travel passing through a pair of cold laminating rolls and thereafter through a pair of hot laminating rolls that effect the final hot lamination of the plastically reflown photoresist film onto the surface of the board.

In order to prevent the cut portion of supported dry photoresist film to fall prematurely over the face of the board with accidental creases, the cut portion of supported photoresist film is sustained off the face of the board by vacuum holders. Therefore, upon resuming the travel through the cold rolls, the dry photoresist film is progressively laid by the rolls onto the board surface.

This known technique including such a cold prelamination has the drawback that the so laid relatively solid dry photoresist film may encapsulate air in the form of microbubbles that can hardly be released during the final hot lamination. This may result in the creation of areas of poor or null adhesion between the finally resolidified photoresist and the copper surface.

Another drawback of this known technique is due to the fact that the tacking of the leading edge of the supported dry photoresist film must be relatively robust to ensure that the ribbon will be dragged along without detecting, even partially. Moreover, the process implies two intervals in which the advancing board is arrested, once for carrying out the tacking of the leading edge of the ribbon and the second for cutting the ribbon to measure, thus greatly limiting the machine's productivity.

More recently, there have been attempts to eliminate the need of arresting the board by separately feeding the board and the supported dry photoresist film directly between the pair of hot laminating rolls and by cutting the portion of dry film ribbon by cutters carried by a follower that moves with the advancing ribbon.

The document EP-A-0356221 discloses a laminating machine in which the tacking bars revolve eccentrically around the hot laminating rolls. In this way, after having performed the tacking of the leading edge of the ribbon, they move out of the lamination zone, thus permitting to the rolls to close onto the board that in this step remains static. With this system, the tacking operation is no longer a critical step because the ribbon must no longer be pulled along by the moving board however the overall process is slowed down. In fact, to the time needed for performing the tacking, the time for rotating the tacking bars off the lamination zone and the time needed for closing the rolls, must be added, before the board may resume its advancing between the hot laminating rolls. Even in this machine, the cutting of the supported dry film ribbon is carried out in a "flying" fashion.

In all these known laminating machines, the necessary plastic reflowing (melting) of the dry photoresist to carry out the hot lamination takes place during the passage between the hot laminating rolls. This is achieved by preheating the incoming board up to a certain temperature and in maintaining the outer elastomer facing of the laminating rolls at a controlled temperature, by the use of IR lamps or of internal electric heating elements of the so-called "candle" type.

Accordingly, the different parameters are adjusted commonly such that, the photoresist material reach a plastically reflow temperature (melting temperature) before the maximum pressure is exerted thereon by the laminating rolls. This is generally accomplished by using an elastomer facing relatively soft such to ensure, at the working pressure, an elastic deformation sufficient to maintain at contact with the cover sheet of the photoresist layer being laminated over the surface of the board for a time interval sufficient to ensure the reaching of the correct laminating temperature by part of the photoresist material upon passing through the point maximum pressure exerted by the elastically deformed outer surfaces of the rolls.

These requisites contrast with the requirement of avoiding entrapment of air and a compromise of these factors must be established for the best possible results.

The document EP-A-314036 discloses an automatic machine for hot laminating a cut to measure dry photoresist film onto a certain area of a board for printed circuit, including a pair of hot laminating rolls, transfer means suitable for feeding a preheated board to the inlet side of said pair of laminating rolls, vacuum holding bars holding a free end portion of the photoresist film, means for pressing and tacking the leading edge of said vacuum held free end portion of the ribbon at a given position on a surface of a board while it is advancing towards the inlet side of said pair of laminating rolls, cutting means for cutting said film ribbon to measure on account of the length of the fed board, while the dry photoresist film ribbon is being carried along by the moving board onto which the leading edge of the ribbon has been tacked by said tacking means, whereby said vacuum holding and tacking bar translates in the direction of advancement of the board starting from an intake or start position at a distance from said hot laminating rolls together with the advancing board while being lowered to tack the vacuum held leading edge of the ribbon at a certain position on a leading edge portion of the surface of the advancing board and successively raised, with vacuum turned off, away from the tacked leading edge, as far as said leading edges are engaged by said hot laminating roll.

### OBJECTIVES AND SUMMARY OF THE INVENTION

The object of the invention is to provide an automatic laminating machine capable of reducing the dead times of the laminating process for an optimal productivity, while at the same time avoiding conditions disfavourable to the release of eventually entrapped air, by limiting to a minimum the elastic deformation of the elastomer facings of the laminating rolls.

This object is achieved by the machine according to claim 1.

In the machine of the invention, the holding means of the free end portion of the supported dry photoresist film ribbon, the tacking means and the cutting means, all translate together with the board, while and upon tacking the leading edge of the held free end portion of the ribbon onto the surface of the board, as far as reaching a position immediately close to the inlet side of the pair of laminating rolls. The cut to measure portion of supported dry photoresist film ribbon, held off the surface of the board is preheated to the desired temperature before being engaged by the laminating rolls.

By preheating the photoresist up to the lamination temperature while still being held off the board surface until it is engaged by the hot laminating rolls permits to use a relatively hard elastomer facing of the laminating rolls, limiting the extent of its elastic deformation.

These conditions of adhering the hot plastically flowing photoresist film to the board by the laminating action exerted by the pair of hot laminating rolls, with a minimum elastic deformation of the cylindrical outer surface of the rolls, favor an outstandingly effective expulsion of air with practically negligible residual entrapment.

It has also been found that adhesion and freedom of entrapment of microbubbles of air may be further enhanced by mutually translating longitudinally one roll relative to the other, in a reciprocating mode at a frequency that may be generally comprised between 10 and 100 Hz and, with an amplitude of travel of few tens of a millimeter. The mutual longitudinal oscillation of one roll in respect to the other during the hot lamination enhances a "spreading" of the plastically reflowing photoresist material, ensuring both an improved adhesion and the release of any entrapped air.

### BRIEF DESCRIPTION OF THE DRAWINGS

These and other aspects and advantages of the machine of the invention will become even more evident through the following description of preferred embodiments and by referring to the attached drawings, wherein:
**Figures 1, 2, 3, 4, 5, 6** and **7** schematically illustrate the functional constitution, relative disposition and coordinated movement of the essential organs of the laminating machine of this invention, during the various phases of a full working stroke of the machine;
**Figure 8a, 8b** and **8c** are enlarged views of the device for cutting to measure of the ribbon in a flying manner.
**Figure 9** shows the means used for preheating the incoming board to a certain temperature;
**Figure 10** shows a preferred embodiment of the preheating means of Fig. 9;
**Figure 11** shows optional devices for mutually oscillating longitudinally the laminating rolls;
**Figure 12** is a simplified illustration of the machine of the invention.

### DESCRIPTION OF SEVERAL PREFERRED EMBODIMENTS OF THE INVENTION

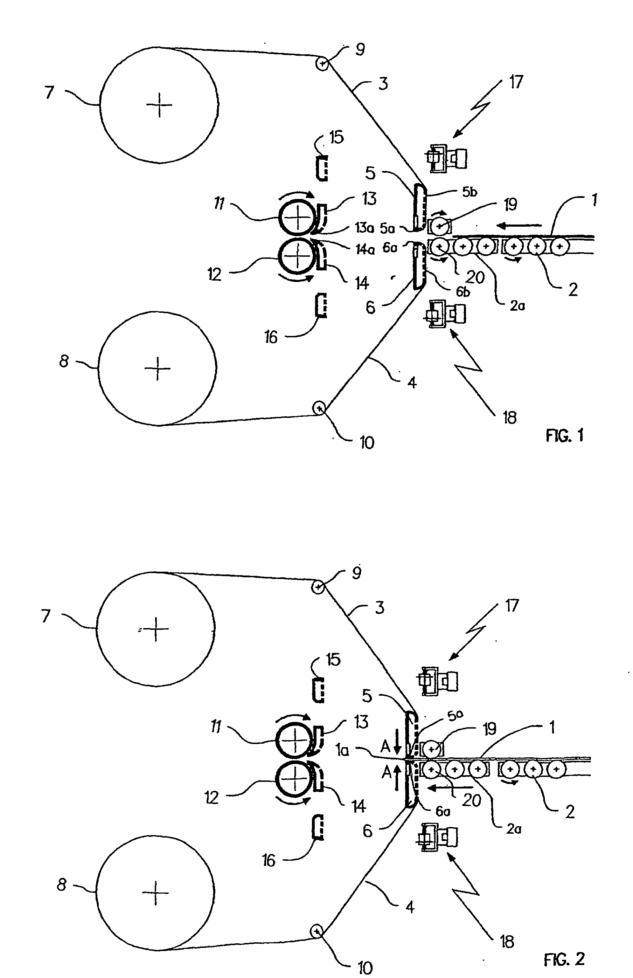

Distinct phases of a full stroke (or cycle) of the automatic machine of the invention are schematically illustrated in the series of Figures 1 to 7.

In the example illustrated, it is assumed that a dry photoresist film is being applied over both faces of a board for printed circuits, being this by far the most common case. Of course, the machine is perfectly suitable for applying the dry photoresist film only on one face of the board, by simply disabling the relevant mechanisms relative to the lamination of a dry photoresist film on the other side of the board.

Fig. 1 represents the essential organs of the automatic machine of the invention in a idling phase or during which the machine is waiting for new board 1 to arrive, generally preheated to a certain temperature.

The board 1 eventually moves toward the laminating section of the machine over a conveyer 2.

In this phase of waiting for a new board 1, the free ends of the two ribbons 3 and 4 of dry photoresist film supported on a peelable cover sheet are held by the respective holding bars 5 and 6. Each holding bar is generally hollow and the interior communicates through a number of holes 5b and 6b uniformly distributed on the ribbon holding face with the outside. A vacuum is maintained inside the bar such that the film ribbon is sucked in and held adherent onto the external face of the bars, practically blocking the suction holes 5b and 6b.

The ribbons 3 and 4 are pulled from the respective supply rolls 7 and 8 and they are properly tensioned by respective guide capstains or pulleys 9 and 10, according to common practice.

The hot laminating rolls 11 and 12 are maintained at a precisely controlled temperature.

Close to the inlet side of the laminating rolls there are secondary vacuum holding bars 13 and 14; having a similarly hollow structure as the primary holding bars 5 and 6, such to suck on and hold the dry photoresist supported film, once it is cut to measure, as will be explained in more detail later.

The two fixed secondary holding bars 13 and 14 or more properly their acute edge portion 13a and 14a defining an inlet gap of the hot lamination zone are also heated at a precisely controlled temperature.

Coplanar with the dry film holding face of the secondary fixed holding bars 13 and 14 and spaced therefrom there are respective hollow counterblade bars 15 and 16, also controllably connected to a vacuum pump in order to eventually suck and hold the dry film ribbon by way of a number of holes open on their dry film holding surface, according to common practices in the art.

In this phase of operation shown in Fig. 1, the two cutter units, indicated as a whole respectively with 17 and 18, are held at a distance and in a position generally coplanar with a terminal pair of drive rolls 19 and 20 of the board conveying train.

Fig. 2 depicts the phase in which the incoming board 1, having been engaged by the terminal pair of drive rolls 19 and 20 of the conveying train, is advanced in the gap between the two primary holding bars 5 and 6.

When the leading edge 1a of the board 1 has advanced to a point in which is projectively under the heated tacking gaskets or inserts 5a and 6a of the respective primary holding bars 5 and 6, the bars are moved one against the other, as shown by the two arrows A in order to press the leading edge portion of the cut end of the dry photoresist film against the respective surface of the board and this tack the cut edge of the ribbon thereon.

This invention, this operation is not done while arresting the travel of the board 1. On the contrary, a terminal portion 2a of the roll conveyor 2, the primary holding and tacking bars 5 and 6, the cutter units 17 and 18, all start to advance together with the board 1.

As shown in Fig. 2, the terminal portion 2a of the roll conveyor away from the fixed portion 2 thereof, carrying on it the board 1, on the faces of which the two leading edges of the dry photoresist ribbons are being tacked.

During this advancement of these parts of the machine, the guide pulleys 9 and 10 maintain the correct tension on the two ribbons 3 and 4.

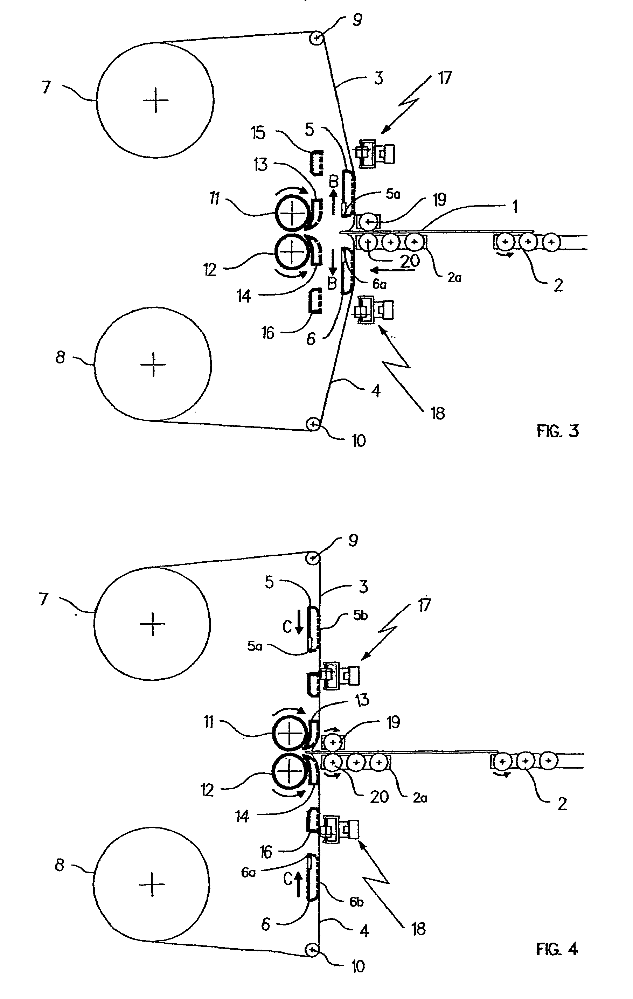

Fig. 3 depicts the phase of approach of the board 1 toward the hot lamination rolls along with the supporting portion 2a of the conveyor.

The tacking of the leading edge of the two dry film ribbons of the leading edge of the board 1 has been completed and, in this phase of operation of the machine, while the whole group of parts moves toward the laminating rolls 11 and 12, the application of vacuum to two primary holding bars 5 and 6 is interrupted and the two bars 5 and 6 start to move off the lamination area, as shown by the arrows B, sliding over the supporting cover sheet of the respective dry film ribbon.

Fig. 4 shows the relative position assumed by the various functional parts of the automatic machine at the time the leading edge of the board 1, pulling along with the tacked-on dry film ribbons reaches the inlet of the hot lamination zone of the machine.

As shown, the pair of primary holding bars 5 and 6 have now moved completely out of the lamination zone, and their holding face is substantially coplanar with the surfaces of the counterblade bars 15 and 16 and with the vacuum suction faces of the secondary holding bars 13 and 14.

At this point, the pair of terminal drive rolls 19 and 20 start to rotate thus continuing to advance the board toward the hot laminating rolls 11 and 12, and simultaneously vacuum is applied again to the primary bars 5 and 6 and to the counterblade bars 15 and 16 and the primary bars 5 and 6 start to move back toward the lamination zone, as shown by the arrows C, together with the counterblade bars 15 and 16, thus feeding the ribbons and avoiding stress on the respective tackings.

So doing, the two dry film ribbons, heated by sliding in contact with the heated secondary bars 13 and 14, are evenly laid on the respective faces of the advancing board 1 and finally adhered thereto by passing through the hot laminating rolls 11 and 12.

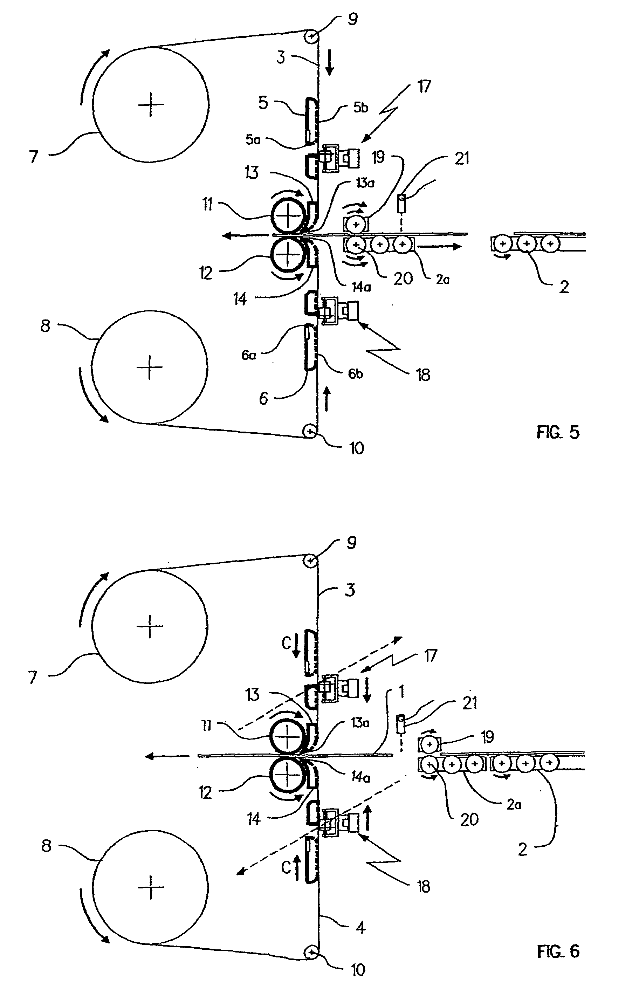

This process is illustrated in Fig. 5, depicting the leading edge of the board having been finally engaged by the hot laminating rolls 11 and 12.

At this points the inward movement of the primary bars 5 and 6 (arrows C of Fig. 4) stops, and the terminal pair of drive rolls 19 and 20 of the portion 2a of the transfer conveyor are idled and the advanced portion 2a of the conveyor is moved back toward the fixed portion of the conveyor 2.

An optical sensor 21 eventually detects the passage of the trailing edge of the board 1 and triggers the action of the cutter units 17 and 18 that cut to measure the respective dry film ribbon in a flying fashion as depicted in Fig. 6.

The cut end portion of the ribbons, held by the respective primary holding bars 5 and 6 is immediately sucked and evenly laid over the rounded comer of the respective bar, the extreme edge portions of the cut ribbons being laid projectively over the tacking inserts 5a and 6a, respectively.

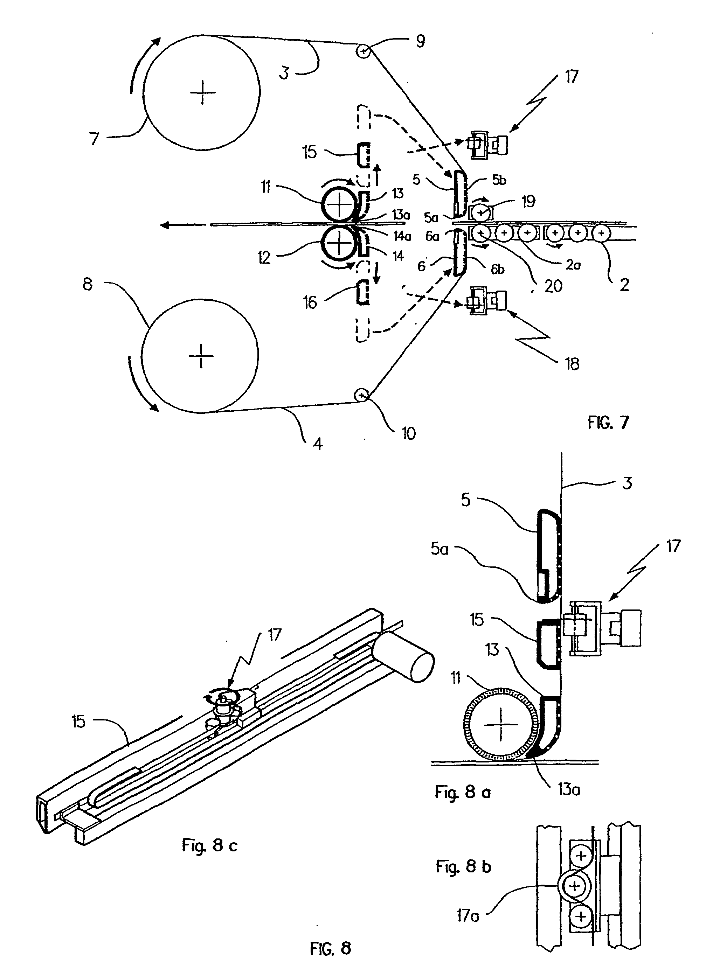

While the board 1 advances through the laminating rolls 11 and 12, adhering the plastically reflow photoresist film to the surface of the board, the cutter units 17 and 18 are moved back to their original position, in substantial alignment with the terminal pair of drive rolls 19 and 20, as depicted in Fig. 7.

The vacuum suction action of the counterblade bars 15 and 16 stops releasing the end of the piece of dry film and they are moved back to their rest position, as depicted by the arrows D.

The cycle just described is repeated for each incoming board.

Fig. 8a is an enlargement view of the hot laminating roll I 1 of the fixed secondary holding and film preheating bar 13, of the counterblade bar 15, of the cutter unit 17 and of the primary holding and tacking bar 5 in their relative position assumed in the phase of the working stroke of the machine depicted in Fig. 5.

The flying cutter wheel 17a may have an ordinary constitution, functionally depicted in the fractional view of Fig. 8b, while a partial three-dimensional view of the flying cutter unit 17 and of the cooperating fixed counterblade bar 15 subassembly is depicted in Fig. 8c.

The laminating rolls 11 and 12 may be conventionally made of steel provided with a facing of a siliconic rubber of a hardness that may be comprised between 50 and 100 shore and most preferably between 60 and 70 shore. The thickness of the uncompressed siliconic rubber facing of the laminating rolls may be comprised between 3 and 10 millimeters, typically of about 5 mm.

The face of the laminating rolls may be maintained at the desired temperature of lamination, in function of the characteristics of the photoresist, either by electric heating elements inserted into the inner steel core of the rolls and/or by external IR lamps. In any case, the temperature is regulated by the use of customary sensors and relative control circuitry.

Also the tacking gasket or insert 5a and 6a of the primary holding and tacking bars 5 and 6 may be of a siliconic rubber, and equally heated to a desired tacking temperature by electric heaters.

The dry photoresist film is preheated to an appropriate plastic reflow temperature upon sliding with their cover sheet face over the hot surface of the secondary holding bars 13 and 14 or most preferably while sliding over the acute end portion thereof, 13a and 14a, that may include a silicon rubber covered electric heater element.

In this way, the photoresist is brought to a temperature of plastic reflow just before being laid and finally hot laminated onto the surface of the board by the hot laminating roll.

Most preferably, as above mentioned, the incoming board 1 is preheated to a certain temperature, generally close to the reflow temperature of the photoresist, before reaching the hot lamination station of the machine.

According to an ancillary aspect of the machine of the invention, the board 1 is preheated by conduction.

This is achieved by having the board passing through and in contact with hot recirculating tapes that are heated by IR lamps illuminating their surface, not in contact with the travelling board 1.

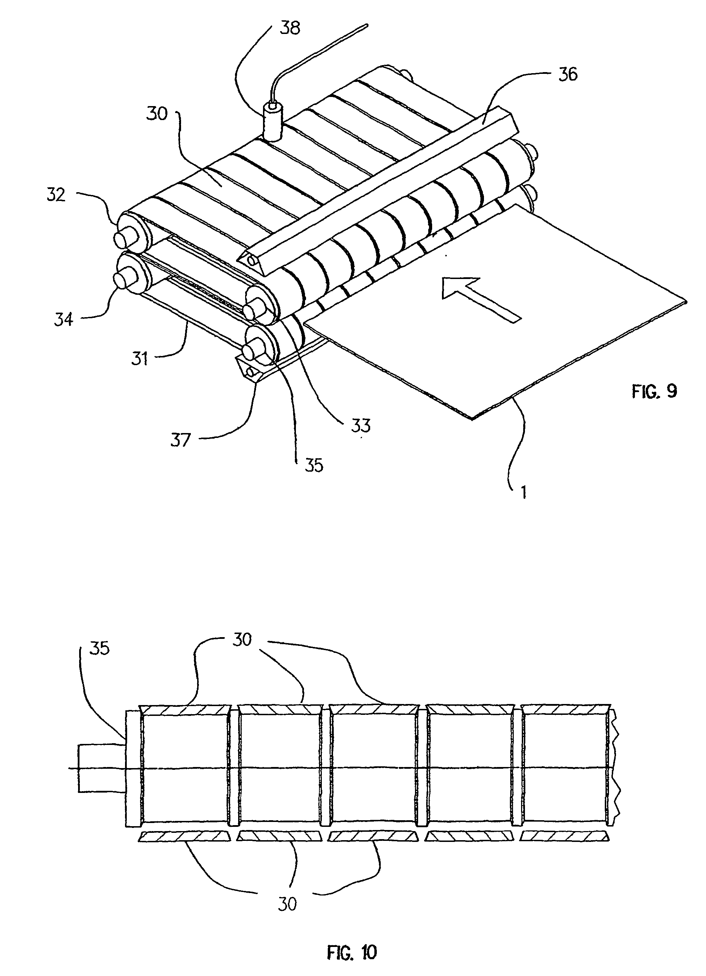

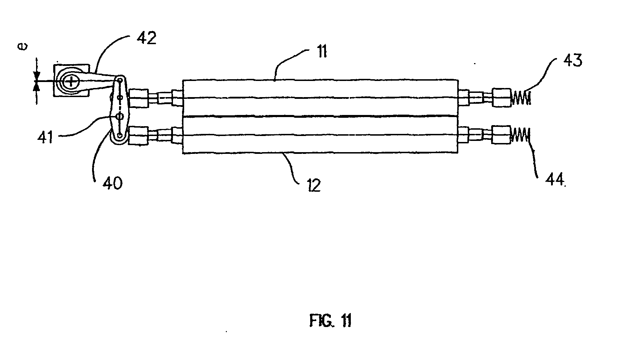

Figures 9 and 10 illustrate a preferred embodiment of the board preheating device.

The hot recirculating tapes 30 and 31 run on a pair of pulleys 32-33 and 34-35, respectively. Of course one of each pair of pulleys is a drive pulley rotated by an appropriate motor.

For sake of ease of control, each heated tape is in practice constituted by a plurality of tapes of fractionary width running over multiple pulley shafts as clearly shown in Fig. 10.

The surface of the circulating tapes not in contact with the travelling board 1 is heated by IR lamps 36 and 37 to a controlled temperature, sensed by appropriate temperature sensors 38.

Heat is transferred to the copper surfaces of the board 1 by travelling in contact with the hot recirculating tapes 30 and 31.

In this way, the problem of the relatively high reflectivity of copper that makes inefficient the heating of the board by direct irradiation is effectively overcome, enhancing energy consumption management of the process.

According to an optional, though preferred embodiment of the hot lamination machine of this invention, the two hot laminating rolls 11 and 12 may be mutually translated longitudinally, one relative to the other, in a reciprocating fashion at a frequency that may be adjustable in function of the tangential velocity of the rolls and generally comprised between 10 and 100 Hz, with an amplitude of travel comprised between 0.1 and 0.6 millimeters.

This optional embodiment is schematically depicted in Fig. 11 that shows an elevation view of the laminating rolls 11 and 12 provided with means for impressing thereon a longitudinal vibration, one in respect to the other. This produces a "spreading" action of the plastically reflow photoresist material over the surface of the board.

The longitudinal vibration may be impressed on the rolls 11 and 12 by way of a pivotal linkage of their shafts by way of a single or of a pair of link plates 40, free to rotate about a central pivot 41.

One end of the link plates 40 may be displaced in a reciprocating fashion by way of an appropriate crank assembly 42.

The high frequency longitudinal vibrations may be elastically contrasted by springs 43 and 44, acting against the opposite ends of the shafts.

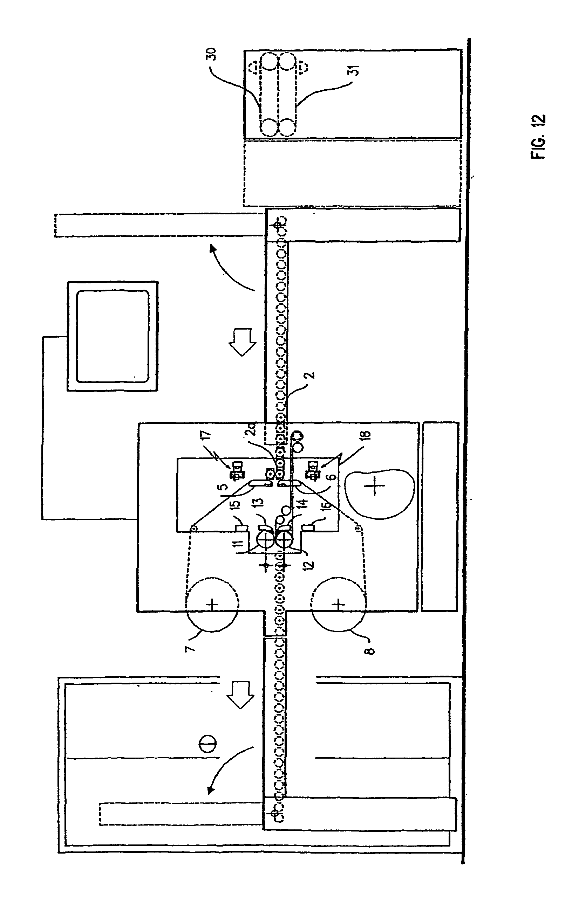

Fig. 12 is a simplified schematic representation of the whole machine, including the board preheating unit.

## Claims

1. An automatic machine for hot laminating a cut to measure dry photoresist film supported on a peelable-off cover sheet **(3, 4)** onto a certain area of a board for printed circuit **(1)**, including a pair of hot laminating rolls **(11, 12),** transfer means **(2, 2a)** for feeding a preheated board **(1)** to the inlet side of said pair of laminating rolls **(11, 12),** at least a supply roll **(7, 8)** of a rolled-up continuous ribbon of said supported dry photoresist film **(3, 4),** at least a movable vacuum operated holding bar **(5, 6)** for holding a free end portion of the supported dry photoresist film ribbon **(3, 4)**, means **(5a, 6a)** for pressing and tacking the leading edge of said vacuum held free end portion of the ribbon at a given position on a surface of a board while it is advancing towards the inlet side of said pair of hot laminating rolls **(11, 12)**, cutting means **(15, 16, 17, 18)** for cutting said supported film ribbon **(3, 4)** to measure on account of the length of the board while the dry photoresist film ribbon **(3, 4)** is being carried along by the advancing board onto which the leading edge of the ribbon has been tacked by said tacking means, and means for preheating said supported dry photoresist film and said advancing board at a certain temperature before laminating them **(1, 3, 4)** together through said pair of heated rolls **(11, 12),** whereby
said vacuum holding and tacking bar **(5, 6)** translates in the direction of advancement of the board **(1)** starting from an intake or start position at a distance from said hot laminating rolls **(11, 12)** together with the advancing board **(1)** while being lowered to tack the vacuum held leading edge of the ribbon **(3, 4)** at a certain position on a leading edge **(1a)** portion of the surface of the advancing board **(1)** and successively raised, with vacuum turned off, away from the tacked leading edge, as far as said leading edges are engaged by said hot laminating roll **(11, 12)**;
thereafter said vacuum holding and tacking bar **(5, 6),** with vacuum turned on, feeds the vacuum held ribbon **(3, 4)** by moving perpendicularly toward the board **(1)** advancing through the hot laminating rolls **(11,12)** until said cutting means **(15, 16, 17, 18)** cut the vacuum held ribbon **(3, 4)** to measure while moving perpendicularly toward the board **(1)** advancing through the hot laminating rolls **(11, 12)** together with said bar **(5, 6)** feeding the ribbon to the advancing board;
said vacuum holding and tacking bar **(5, 6)** and a blade portion **(17, 18)** of said cutting means returning to their intake positions after having cut the ribbon;
at least a secondary stationary vacuum operated holding bar **(13, 14)** holding the trailing portion of the cut-to-measure ribbon **(3, 4)** off the surface of the board **(1)** until it enters the gap between the hot laminating rolls **(11, 12)**.

2. The automatic machine according to claim 1, wherein said vacuum holding and tacking bar **(5, 6)** has means for heating the photoresist film to a certain tacking temperature and said means **(5a, 6a)** for pressing and tacking the leading edge of said ribbon maintain a pressure on the tacked leading edge of the ribbon while travelling together with the board until said vacuum holding and tacking bar **(5, 6)** is raised away.

3. The machine of claim 1, wherein electric heaters for preheating the photoresist film **(3, 4)** to the hot lamination temperature before it is adhered to the surface of the board **(1)** upon passing through the gap between said pair of laminating rolls **(11, 12)** are present in said secondary stationary vacuum operated holding bar **(13,14)**.

4. The machine of claim 1, wherein each board **(1)** is preheated by travelling in contact with an upper and a lower heated tapes (30, 31), each circulating over at least two pulleys **(32, 33, 34, 35)** and continuously heated by IR lamps **(36, 37)** illuminating the face of the recirculating tape portion not in contact with the surface of the travelling board **(1)**.

5. The machine according to claim 4, wherein each recirculating tape **(30, 31)** is constituted by a plurality of tapes of fractionary width running over multiple pulleys shafts.

6. The machine according to any of the preceding claims **characterized in that** it comprises means for mutually translating longitudinally one hot laminating roll **(11)** relative to the other **(12)** in a reciprocating fashion at a frequency adjustable in function of the tangential velocity of the rolls and comprised between 10 and 100 Hz and with an amplitude of travel comprised between 0.1 and 0.6 mm.

7. The machine according to any of the preceding claims in which at least one of said hot laminating rolls has a steel core and an outer facing of an elastomer having a hardness comprised between 50 and 100 shore.

8. The machine according to claim 7, wherein the hardness of the elastomer facing is comprised between 60 and 70 shore.

9. The machine according to claim 1, wherein said secondary stationary vacuum operated holding bar **(13, 14)** has the form of a transverse bar having a tubular cross section with a contoured curved perimeter, a forward wall of which conforms to the cylindrical outer surface of the laminating roll and a rearward wall of which has a curved profile on which the supported dry photoresist film ribbon **(3, 4)** is held by a vacuum applied to interior of the tubular cross section bar communicating with a plurality of suction holes present in said curved rearward wall of the bar.

10. The machine according to claim 1, wherein said means for pressing and tacking **(5a, 6a)** are in the form of a heated elastomer facing fitted along an edge of said vacuum operated holding and tacking bar **(5, 6),** formed at the conjunction of a forward wall and of a rearward wall of the bar provided with a plurality of suction holes.

11. The machine according to any of the preceding claims, in which an end portion **(2a)** of said transfer means **(2)** for feeding a preheated board translates forward with the board supported thereon together with said vacuum operated holding and tacking bar **(5, 6)** and with said cutting means **(17, 18),** from said intake positions.

## Patentansprüche

1. Automatische Maschine zum Heißwalzen eines zugeschnittenen Trockenphotoresist Filmes (3, 4), der auf einer abschälbaren Deckelfolie aufgetragen ist, auf einen gewissen Bereich einer Leiterplatte (1), umfassend:
ein Paar Walzen zum Heißlaminieren (11, 12), Übertragungsmittel (2, 2a) zum Zuführen einer Vorerwärmten Platte (1) zur Einlassseite des genannten Paar Laminierwalzen (11, 12), mindestens eine Zufuhrwalze (7, 8) für ein unendliches aufgewickeltes Band des genannten getragenen Trockenphotoresist Filmes (3, 4), mindestens einen verstellbaren vakuumgesteuerten Haltestab (5, 6) zum *Tragen* eines freien Endteils des getragenen Trockenphotoresist Film Bandes (3, 4), Mittel (5a, 6a) zum Aufdrücken und Anhaften der durch Vakuumeinwirkung gehalterten Vorderkante des genannten freien Endteils des Bandes in einer bestimmten Lage auf einer Oberfläche einer Platte während ihrer Vorwärtsbewegung in Richtung Einlassseite des genannten Paar Heißlaminierwalzen (11, 12), Schneidmittel (15, 16, 17, 18) zum Zuschneiden des genannten getragenen Trockenphotoresist Film Bandes (3, 4), im Hinblick auf die Länge der Platte während der Trockenphotoresist Film Band (3, 4) durch die beförderte Platte auf welche die Vorderkante des Bandes durch die genannte Anhaftungsmittel haftend aufgetragen wurde, und Mittel zum Vorerwärmen des genannten getragenen Trockenphotoresist Filmes und der genannten beförderten Platte auf eine bestimmte Temperatur bevor sie (1, 3, 4) miteinander laminiert werden durch das genannte Paar erwärmte Walzen (11, 12), wobei
der genannte vakuumgesteuerte Halte- und Auftragstab (5, 6) in der Förderungsrichtung der Platte (1) beginnend von einer Einlass- bzw. Startposition auf Abstand von den genannten Heißlaminierwalzen (11, 12) zusammen mit der vorwärts beförderten Platte (1) verstellt wird und gleichzeitig abgesenkt wird zum haftenden Auftragen der durch Vakuumeinwirkung gehalterten Vorderkante des Bandes (3, 4) in einer bestimmten Lage auf eine Vorderkantenteil (1a) auf der Oberfläche der vorwärts beförderten Platte (1) und danach von der haftend gemachten Vorderkante aufgehoben wird, unter Abschaltung der Vakuumeinwirkung, bis die genannte Vorderkanten mit den genannten Heißlaminierwalzen (11, 12) in Eingriff gebracht werden;
danach befördert der genannte vakuumgesteuerte Halte- und Auftragstab (5, 6), unter Einschaltung der Vakuumeinwirkung, das durch Vakuum gehalterte Band (3, 4) indem er rechtwinklig in Richtung Platte (1) unter Vorschub durch die Heißlaminierwalzen (11, 12) bewegt wird, bis die genannte Schneidemittel (15, 16, 17, 18) das durch Vakuum gehalterte Band (3, 4) zuschneiden während sie rechtwinklig in Richtung Platte (1) unter Vorschub durch die Heißlaminierwalzen (11, 12) zusammen mit dem genannten Stab (5, 6), der die vorgeschobene Platte mit dem Band versorgt, bewegt werden;
wobei der genannte vakuumgesteuerte Halte- und Auftragstab (5, 6) und ein Klingenteil (17, 18) der genannten Schneidmittel, nachdem sie das Band geschnitten haben, zu deren Einlasslagen zurückgekehrt werden;
und wobei mindestens ein sekundärer stationärer vakuumgesteuerter Haltestab (13, 14) die Hinterkante des zugeschnittenen Bandes (3, 4) von der Oberfläche der Platte (1) rückhalt, bis es in den Abstand zwischen den Heißlaminierwalzen (11, 12) eingefügt wird.

2. Automatische Maschine nach Anspruch 1, wobei der genannte vakuumgesteuerte Halte- und Auftragstab (5, 6) Mittel zum Aufheizen des Photoresist Filmes auf eine bestimmte Haftungstemperatur aufweist, und die genannte Mittel (5a, 6a) zum Drücken und haftend Auftragen der Vorderkante des genannten Bandes einen auf die haftend aufgetragene Vorderkante einwirkenden Druck während sie zusammen mit der Platte befördert werden ausüben, bis der genannte vakuumgesteuerte Halte- und Auftragstab (5, 6) aufgehoben und entfernt wird.

3. Die Maschine nach Anspruch 1, wobei der genannte sekundäre stationäre vakuumgesteuerte Haltestab (13, 14) elektrische Heizmittel zur Vorerwärmung des Photoresist Filmes (3, 4) auf die Heißlaminieren Temperatur bevor er zur Oberfläche der Platte (1) haftend aufgetragen wird nachdem er durch den Abstand zwischen den genannten beiden Laminierwalzen (11, 12) gefahren worden ist aufweist.

4. Die Maschine nach Anspruch 1, wobei jede Platte (1) durch Bewegung in Berührung mit einem unteren und einem oberen aufgeheizten Band (30, 31) vorerwärmt wird, wobei jedes der genannten Bänder (30, 31) über mindestens zwei Riemenscheiben (32, 33, 34, 35) umläuft und kontinuierlich durch IR-Lampen (36, 37) aufgeheizt wird, die diejenige Seite des umgewälzten Bandteiles belichtet, die nicht in Berührung mit der Oberfläche der beförderten Platte (1) ist.

5. Die Maschine nach Anspruch 4, wobei jedes umgewälzte Band (30, 31) aus einer Mehrzahl Bänder mit bruchzähliger Weite besteht, die sich auf mehrere Riemenscheibenwellen erstrecken.

6. Die Maschine nach irgendeinem der vorhergehenden Ansprüche, **dadurch gekennzeichnet, dass** sie Mittel zur alternierenden gegenseitigen Verschiebung in Längsrichtung einer Heißlaminierwalze (11) in Bezug auf die andere (12) umfasst, wobei die Frequenz der Verschiebung in Abhängigkeit von der Umfangsgeschwindigkeit der Walzen steuerbar ist und zwischen 10 und 100 Hz beträgt, während ihre Bewegungsamplitude zwischen 0,1 und 0,6 mm beträgt.

7. Die Maschine nach irgendeinem der vorhergehenden Ansprüche, in welcher mindestens eine des genannten Heißlaminierwalzen einen Stahlkern und eine Außenbeschichtung aus einem Elastomer dessen Härte zwischen 50 und 100 Shore beträgt aufweist.

8. Die Maschine nach Anspruch 7, wobei die Härte der elastomeren Beschichtung zwischen 60 und 70 Shore beträgt.

9. Die Maschine nach Anspruch 1, wobei der genannte sekundäre stationäre vakuumgesteuerte Haltestab (13, 14) die Form eines Querstabes aufweist mit einem rohrförmigen Querschnitt mit konturiertem gebogenem Umfang, dessen eine Stirnwand mit der Form der zylindrischen Außenwand der Laminierwalze übereinstimmt und dessen eine Bodenwand einen gebogenen Kontur aufweist, auf welchem das getragene Trockenphotoresist Filmband (3, 4) durch ein Vakuum rückgehalten wird, das im Inneren des Stabes mit rohrförmigem Querschnitt erzeugt wird, der mit einer Mehrzahl Saugbohrungen in Verbindung steht, die in der genannten gebogenen Bodenwand des Stabes vorgesehen sind.

10. Die Maschine nach Anspruch 1, wobei die genannte Mittel (5a, 6a) zum Aufdrücken und haftenden Auftragen die Form einer aufgeheizten elastomeren Beschichtung aufweisen, die einer Kante des genannten vakuumgesteuerten Halteund Auftragstabes (5, 6) entlang aufgezogen ist und bei der Füge zwischen einer Stirnwand und einer Bodenwand des mit einer Mehrzahl Saugbohrungen gebildeten Stabes gebildet ist.

11. Die Maschine nach irgendeinem der vorhergehenden Ansprüche, in welcher ein Endteil (2a) des genannten Übertragungsmittels (2) zum Zuführen einer Vorerwärmten Platte mit der Platte darauf gelagert zusammen mit dem genannten vakuumgesteuerten Halte- und Auftragstab (5, 6) und mit den genannten Schneidemittel (17, 18) von der genannten Einlasslage vorwärts bewegt wird.

## Revendications

1. Machine automatique pour le laminage à chaud d'une pellicule de photorésist à sec coupé à mesure supporté sur une feuille de couverture amovible par écorçage (3, 4) sur une certaine aire d'une plaquette à circuit imprimé (1), incluant un couple de rouleaux pour laminage à chaud (11, 12), des moyens de transfert (2, 2a) pour alimenter une plaquette préchauffée (1) au coté d'entrée dudit couple de rouleaux de laminage (11, 12), au moins un rouleau d'alimentation (7, 8) d'un ruban continu enroulé de ladite pellicule de photorésist à sec (3, 4) supportée, au moins une barre de rétention mobile (5, 6) commandée par action de vide afin de retenir une portion terminale libre du ruban de pellicule de photorésist à sec (3, 4) supporté, des moyens (5a, 6a) pour presser et appliquer adhésivement le bord avant de ladite portion terminale libre retenue par action de vide du ruban en une position donnée sur une surface d'une plaquette en tant qu'elle avance vers le coté d'entrée dudit couple de rouleaux de laminage (11, 12), des moyens de coupage (15, 16, 17, 18) pour couper à mesure ledit ruban de pellicule (3, 4) supporté compte tenu de la longueur de la plaquette en tant que le ruban de pellicule de photorésist à sec (3, 4) est transporté le long de la plaquette qui avance sur laquelle le bord avant du ruban a été appliqué adhésivement par ledit moyen adhésif, et des moyens pour préchauffer ladite pellicule de photorésist à sec supportée et ladite plaquette qui avance à une certaine température avant qu'elles soient laminées (1, 3, 4) ensemble en passant à travers dudit couple de rouleaux chauffés (11, 12), où
ladite barre de rétention et application adhésive (5, 6) commandée par action de vide coulisse dans la direction d'avancement de ladite plaquette (1) à partir d'une position d'introduction ou départ à une certaine distance desdits rouleaux de laminage à chaud (11, 12) ensemble avec la plaquette qui avance (1) en tant qu'elle est baissée pour appliquer adhésivement le bord avant retenu par action de vide du ruban (3, 4) dans une certaine position sur une portion de bord avant (1a) de la surface de la plaquette qui avance (1) et ensuite soulevée, avec le vide désactivé, pour l'éloigner du bord avant appliqué adhésivement, jusqu'à ce que lesdits bords avant sont engagés par ledit rouleau de laminage à chaud (11, 12),
après, ladite barre de rétention et application adhésive (5, 6) commandée par action de vide, avec le vide activé, amène le ruban (3, 4) retenu par action de vide en coulissant perpendiculairement vers la plaquette (1) qui avance à travers des rouleaux de laminage à chaud (11, 12) jusqu'à ce que lesdits moyens de coupage (15, 16, 17, 18) coupent le ruban (3, 4) retenu par action de vide à la mesure au cours du coulissement en direction perpendiculaire envers la plaquette (1) qui avance à travers les rouleaux de laminage à chaud (11, 12) ensemble avec ladite barre (5, 6) qui amène le ruban à la plaquette (1) qui avance;
ladite barre de rétention et application adhésive (5, 6) commandée par action de vide et une portion de lame (17, 18) dudit moyen de coupage retournant à leur positions d'introduction après avoir coupé le ruban ;
au moins une barre de rétention secondaire stationnaire (13, 14) commandée par action de vide retenant la portion de fuite du ruban (3, 4), coupé à la mesure, loin de la surface de la plaquette (1) jusqu'à ce qu'elle entre dans la séparation existant entre les rouleaux de laminage à chaud (11, 12).

2. La machine automatique selon la revendication 1, dans laquelle ladite barre de rétention et application adhésive (5, 6) commandée par action de vide est pourvue de moyens pour le chauffage de la pellicule de photorésist jusqu'à une certaine température d'adhésion, et lesdits moyens (5a, 6a) pour presser et appliquer adhésivement le bord avant dudit ruban maintiennent une pression sur le bord avant appliqué adhésivement du ruban en tant qu'ils coulissent ensemble avec la plaquette jusqu'à ce ladite barre de rétention et application adhésive (5, 6) commandée par action de vide est éloignée par soulèvement.

3. La machine selon la revendication 1, dans laquelle il y a des réchauffeurs pour le préchauffage de la pellicule de photorésist (3, 4) à la température de laminage à chaud avant qu'elle soit appliquée adhésivement à la surface de la plaquette (1) après son passage à travers de la séparation existant entre ledit couple de rouleaux de laminage à chaud (11, 12) dans ladite une barre de rétention secondaire stationnaire (13, 14) commandée par action de vide.

4. La machine selon la revendication 1, dans laquelle chaque plaquette (1) est préchauffée en coulissant en contact avec des rubans chauffés supérieur et inférieur (30, 31), chacun des quels roule sur au moins deux poulies (32, 33, 34, 35) et est chauffé en continu par des lampes IR (36, 37) qui illuminent la face de la portion de ruban ré circulant qui n'est pas en contact avec la surface de la plaquette (1) qui avance.

5. La machine selon la revendication 4, dans laquelle chaque ruban ré circulant (30, 31) est constitué d'une pluralité de rubans de largeur fractionnaire qui marchent sur une pluralité d'arbres de poulie.

6. La machine selon l'une quelconque des revendication précédentes, **caractérisée en ce qu'**elle comprend des moyens pour faire coulisser en direction longitudinale un rouleau de laminage à chaud (11) par rapport à l'autre rouleau de laminage à chaud (12) dans une modalité alternative à une fréquence qui peut être réglée en fonction de la vitesse tangentielle des rouleaux et comprise entre 10 et 100 Hz et avec une amplitude d'écoulement comprise entre 0,1 et 0,6 mm.

7. La machine selon l'une quelconque des revendication précédentes, dans laquelle au moins un desdits rouleaux de laminage à chaud a un noyau d'acier et un revêtement extérieur en élastomère ayant une dureté comprise entre 50 et 100 Shore.

8. La machine selon la revendication 7, dans laquelle la dureté du revêtement en élastomère est comprise entre 60 et 70 Shore.

9. La machine selon la revendication 1, dans laquelle ladite barre de rétention secondaire stationnaire (13, 14) commandée par action de vide a la forme d'une barre transversale ayant une section tubulaire avec un périmètre courbe contourné, une paroi antérieure de laquelle est conforme à la surface extérieure cylindrique du rouleau de laminage et une paroi postérieure de laquelle a un profil courbe sur lequel le ruban de pellicule de photorésist à sec (3, 4) supporté est retenu par l'effet d'une vide appliquée à l'intérieur de la barre à section transversale tubulaire qui est en communication avec une pluralité de trous d'aspiration qui sont présents dans ladite paroi postérieure courbe de la barre.

10. La machine selon la revendication 1, dans laquelle lesdits moyens (5a, 6a) pour presser et appliquer adhésivement se présentent dans la forme d'un revêtement en élastomère chauffé appliquée de façon adhérente le long d'une arête de ladite barre de rétention et application adhésive (5, 6) commandée par action de vide, formée à la jonction d'une paroi antérieure et d'une paroi postérieure de la barre, pourvue d'une pluralité de trous d'aspiration.

11. La machine selon l'une quelconque des revendication précédentes, dans laquelle une portion terminale (2a) dudit moyen de transfert (2) pour l'avancement d'une plaquette préchauffée coulisse en avant en supportant plaquette, ensemble avec ladite barre de rétention et application adhésive (5, 6) commandée par action de vide et avec lesdits moyens de coupage (17, 18), en s'éloignant de ladite position d'introduction.
